# FASCICULE DE BREVET EUROPEEN

(11) **EP 3 665 226 B1**
(45) Date de publication et mention de la délivrance du brevet: **30.08.2023**
(21) Numéro de dépôt: 18762380.6
(22) Date de dépôt: 07.08.2018
(51) Int. Cl.: C08L 27/16, H10K 10/46, H10N 30/857

(54) **COMPOSITION DE POLYMÈRES FLUORÉS ÉLECTROACTIFS, FORMULATION, FILM, DISPOSITIF ÉLECTRONIQUE ET TRANSISTOR ORGANIQUE A EFFET DE CHAMP**
ZUSAMMENSETZUNG VON FLUORIERTEN ELEKTROAKTIVEN POLYMEREN, FORMULIERUNG, FILM, ELEKTRONISCHE VORRICHTUNG UND ORGANISCHER FELDEFFEKTTRANSISTOR
COMPOSITION OF FLUORINATED ELECTROACTIVE POLYMERS, FORMULATION, FILM, ELECTRONIC DEVICE AND ORGANIC FIELD-EFFECT TRANSISTOR

(30) Priorité: 09.08.2017 FR 1757604
(43) Date de publication de la demande: 17.06.2020
(73) Titulaire: Arkema France, 92700 Colombes (FR); Université de Bordeaux, 33000 Bordeaux (FR); Institut Polytechnique de Bordeaux, 33402 Talence Cedex (FR); Centre National de la Recherche Scientifique, 75016 Paris (FR)
(72) Inventeur: DOMINGUES DOS SANTOS, Fabrice, 75003 Paris (FR); SOULESTIN, Thibaut, 69007 Lyon (FR); THUAU, Damien, 33000 Bordeaux (FR); HADZIIOANNOU, Georges, 33850 Léognan (FR)
(74) Mandataire: Arkema Patent
(86) Numéro de dépôt international: PCT/FR2018/052029
(87) Numéro de publication internationale: WO 2019/030453

(56) Documents cités:
- WO-A1-2016/039830
- US-A1- 2016 087 185
- XIANG-ZHONG CHEN ET AL: "Enhanced electrocaloric effect in poly(vinylidene fluoride-trifluoroethylene)-based terpolymer/copolymer blends", APPLIED PHYSICS LETTERS, vol. 100, no. 22, 28 mai 2012 (2012-05-28) , page 222902, XP055469945, US ISSN: 0003-6951, DOI: 10.1063/1.4722932
- BAOJIN CHU ET AL: "Energy storage properties of PVDF terpolymer/PMMA blends", HIGH VOLTAGE, vol. 1, no. 4, 1 décembre 2016 (2016-12-01), pages 171-174, XP055470238, DOI: 10.1049/hve.2016.0062
- SOON-WON JUNG ET AL: "Low-voltage-operated top-gate polymer thin-film transistors with high-capacitance P(VDF-TrFE)/PVDF-blended dielectrics", CURRENT APPLIED PHYSICS, NORTH-HOLLAND, AMSTERDAM, NL, vol. 11, no. 3, 13 janvier 2011 (2011-01-13), pages S213-S218, XP028331986, ISSN: 1567-1739, DOI: 10.1016/J.CAP.2011.01.011 [extrait le 2011-01-22]
- AMIR ULLAH ET AL: "Enhancement of dielectric and energy density properties in the PVDF-based copolymer/terpolymer blends", POLYMER ENGINEERING AND SCIENCE., vol. 55, no. 6, 7 April 2015 (2015-04-07), pages 1396-1402, XP055486653, US ISSN: 0032-3888, DOI: 10.1002/pen.24083

## Description

### DOMAINE DE L'INVENTION

La présente invention concerne une composition comprenant un mélange de polymères fluorés électroactifs et présentant une permittivité diélectrique plus stable sur la gamme de température d'utilisation par rapport à chaque polymère employé seul. L'invention concerne aussi des formulations et des films réalisés à partir de ladite composition. L'invention concerne également un transistor à effet de champ dont au moins une partie de la couche diélectrique est composée d'un mélange de polymères fluorés électroactifs. L'invention se rapporte enfin à un dispositif (opto)électronique dont au moins une couche ou film est composée d'un mélange de polymères fluorés ferroélectriques avec une permittivité diélectrique considérée comme stable sur la gamme de température d'utilisation.

### ARRIERE-PLAN TECHNIQUE

Les polymères électroactifs sont parmi les matériaux les plus prometteurs pour l'électronique organique. Les polymères électroactifs sont des polymères capables de convertir l'énergie mécanique ou thermique en électricité ou vice-versa. Parmi ces matériaux figurent les copolymères fluorés à base de fluorure de vinylidène (VDF) et de trifluoroéthylène (TrFE).

Ces polymères fluorés électroactifs (PFEAs) sont ferroélectriques, c'est-à-dire qu'ils possèdent une polarisation électrique spontanée qui peut être inversée par l'application d'un champ électrique. Typiquement, les PFEAs possèdent une polarisation spontanée, sous un champ électrique de 150 MV/m, comprise entre 40 et 120 mC/m². Parmi ces polymères, certains terpolymères de type P(VDF-TrFE-Y) avec Y étant, de préférence, le chlorotrifluoroéthylène (CTFE) ou le chlorofluoroéthylène (CFE) ; sont des PFEAs ferroélectriques relaxeurs.

Les PFEAs possèdent une permittivité diélectrique relativement élevée (supérieure à 10) pour des matériaux polymères. Une permittivité diélectrique élevée permet l'utilisation de ces polymères dans la fabrication de dispositifs pour l'électronique, notamment l'électronique organique et plus particulièrement des transistors à effet de champ. En effet, l'utilisation de polymères à permittivité diélectrique élevée permet de réduire la consommation électrique des transistors en réduisant la tension devant être appliquée à la grille (« gate » en anglais) nécessaire pour rendre conductrice la couche de semi-conducteur.

La permittivité diélectrique d'un PFEA varie en fonction de la température et est maximale à une température communément appelée « température de Curie (Tc) ». Pour les polymères ferroélectriques classiques, P(VDF-TrFE), ce maximum correspond à une transition d'une phase ferroélectrique vers une phase paraélectrique quand la température augmente. De plus, la Tc est indépendante de la fréquence du champ électrique. En revanche, dans le cas d'un polymère ferroélectrique relaxeur, la Tc varie en fonction de la fréquence du champ électrique. Le maximum de permittivité diélectrique peut atteindre, voire dépasser 30 à la Te. La Tc varie entre 15 et 140°C en fonction de la composition des PFEAs (ratio VDF/TrFE et taux de termonomère Y).

Les variations de permittivité diélectrique influent sur les performances des dispositifs électroactifs. En effet, de nombreuses propriétés telles que la polarisation et la déformation sont directement liées à la permittivité. De manière générale, les dispositifs électroactifs sont intégrés à des équipements électroniques non-régulés en température. Afin de garder des propriétés constantes, il faut développer des systèmes permettant de compenser ces variations. Ces systèmes souvent complexes et onéreux limitent l'utilisation des PFEAs dans certains équipements électroniques. Maintenir une permittivité diélectrique élevée et constante sur une plus grande plage de température est nécessaire pour favoriser le développement des dispositifs électroactifs. Dans un cas particulier de dispositif électroactif, le développement de transistors à effet de champ contenant une couche diélectrique à haute permittivité requiert des propriétés stables en température pour assurer le bon fonctionnement du dispositif.

Le document EP 0206926 décrit des mélanges de polymères ferroélectriques à températures de Curie différentes, ces alliages visant à optimiser les propriétés diélectriques sur une gamme de températures et de fréquences étendue. Le mélange d'un terpolymère P(VDF-TrFE-CTFE), contenant 10 pourcent molaire de CTFE, avec un copolymère P(VDF-TrFE), de composition molaire VDF-TrFE 60-40, (alliage I, correspondant à la courbe 18 de la figure 7), permet l'obtention d'un matériau de constante diélectrique relative comprise entre 20 et 30 pour une gamme de températures s'étalant de 20 à 100°C et dont le maximum se situe autour de 80°C. Ces valeurs de permittivité relative, inférieure à 30 et avec une variation de +/- 5 par rapport à une valeur moyenne de 25, restent toutefois insuffisantes pour certaines applications, notamment dans la fabrication des transistors.

Il existe donc un besoin de mettre au point une composition présentant une permittivité diélectrique élevée et constante sur une plus grande plage de températures. L'invention vise également à fournir des transistors à effet de champ dont une couche diélectrique est constituée d'un mélange de polymères fluorés électroactifs à haute permittivité diélectrique et stable sur une large gamme de température. L'optimisation du mélange de polymères permet d'obtenir une permittivité diélectrique plus stable, entre 15 et 120 °C, que celle obtenue pour un seul polymère.

### RESUME DE L'INVENTION

L'invention concerne en premier lieu une composition comprenant un mélange de polymères fluorés électroactifs, ledit mélange étant composé :
a) d'au moins un terpolymère fluoré de formule P(VDF-X-Y) comprenant des unités issues du fluorure de vinylidène (VDF), des unités issues d'un monomère X choisi parmi le trifluoroéthylène (TrFE), le tétrafluoroéthylène, le chlorotrifluoroéthylene (CTFE), le fluorure de vinyle, le 1,1-chlorofluoroéthylène, l'hexafluoropropène, le 3,3,3-trifluoropropène, le 1,3,3,3-tétrafluoropropène, le 2,3,3,3-tétrafluoropropène, le 1-chloro-3,3,3-trifluoropropène et le 2-chloro-3,3,3-trifluoropropène, et d'un tiers monomère Y,
b) et d'au moins un copolymère de formule P(VDF-TrFE) comprenant des unités issues du fluorure de vinylidène et des unités issues du trifluoroéthylène, la proportion d'unités issues du trifluoroéthylène étant supérieure à 45 mol.% par rapport à la somme des unités issues du fluorure de vinylidène et du trifluoroéthylène.

Selon diverses réalisations, ladite composition comprend les caractères suivants, le cas échéant combinés.

Selon un mode de réalisation, le tiers monomère est le chlorofluoro-1,1-éthylène ou le chlorotrifluoroéthylène.

Selon un mode de réalisation, la proportion d'unités issues du monomère Y est de 1 à 15 mol.%, de préférence encore de 1 à 12 mol.%, par rapport à la totalité des unités dudit terpolymère.

Selon un mode de réalisation, le terpolymère fluoré (composant a) et le copolymère fluoré (composant b) sont présents dans un rapport massique de 50:50 à 99:1, de préférence de 55:45 à 99:1, de manière plus particulièrement préférée de 60:40 à 95:5.

Selon un mode de réalisation, la composition selon l'invention comprend en outre jusqu'à 2% en poids d'un additif, ledit additif étant un polymère (méth)acrylique, notamment le poly(méthyl méthacrylate).

L'invention concerne également une formulation (ou encre) réalisée à partir du mélange de polymères fluorés décrit plus haut, en solution dans un solvant.

Un autre objet de l'invention est un film ou couche de polymère réalisé à partir de ladite formulation. Cette couche possède une permittivité diélectrique plus stable sur la gamme de températures d'utilisation par rapport à un polymère fluoré électroactif utilisé seul.

L'invention concerne également un dispositif (opto)électronique comprenant un substrat, et un film préparé à partir de la formulation décrite ci-dessus disposé sur celui-ci.

Selon un mode de réalisation, le dispositif comprend en outre des électrodes de part et d'autre du film, ledit dispositif étant de préférence un actionneur.

L'invention concerne également un transistor organique à effet de champ comprenant un élément semi-conducteur, des électrodes et une couche diélectrique à haute permittivité diélectrique stable en température. De manière caractéristique, la couche diélectrique est composée au moins en partie de la composition selon l'invention décrite ci-dessus.

La présente invention permet de surmonter les inconvénients de l'état de la technique. Elle fournit plus particulièrement une composition présentant une permittivité diélectrique élevée et constante sur une plus grande plage de températures. Cela est accompli grâce à l'association entre un terpolymère fluoré électroactif et un copolymère compatible avec le terpolymère, présentant une température de Curie différente de celle du terpolymère.

Elle est particulièrement appropriée pour la fabrication de matériaux diélectriques pour transistors organiques. La stabilité en température de la permittivité diélectrique améliore la performance des transistors organiques pour une utilisation dans une large gamme en température.

### FIGURES

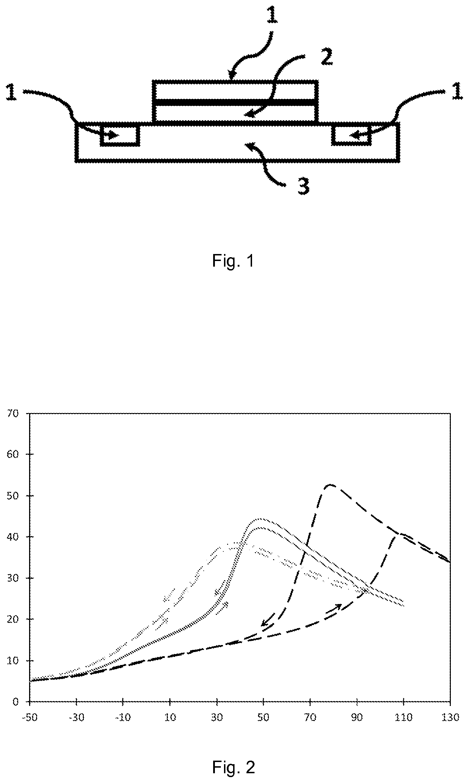

La Figure 1 représente le schéma de principe d'un transistor à effet de champ. Les éléments 1 représentent les trois électrodes : source, grille («gate») et drain. L'élément 2 représente la couche diélectrique qui est dans l'invention composée d'au moins une couche réalisée à partir d'un mélange de polymère fluorés électroactifs à haute permittivité diélectrique. L'élément 3 est le semi-conducteur.
La Figure 2 est un graphique illustrant des courbes de permittivité relative (axe des ordonnées), mesurée à 1 kHz, en fonction de la température (axe des abscisses) (montée puis descente) de trois polymères fluorés électroactifs : P(VDF-TrFE-CTFE) (courbe tiret-pointillés), P(VDF-TrFE-CTFE) (courbe pleine) et P(VDF-TrFE) (courbe tirets). Les compositions molaires VDF/TrFE/Y des polymères sont de: 60/30/10, 61/35/4, 70/30, respectivement.

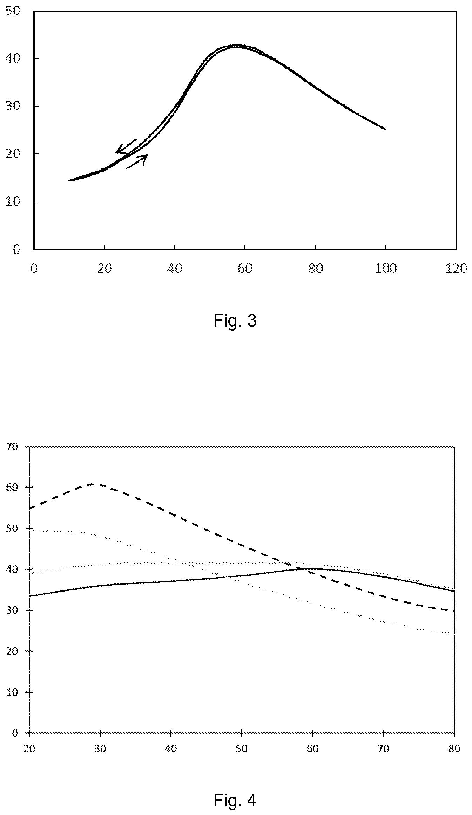

La Figure 3 est un graphique illustrant des courbes de permittivité relative (axe des ordonnées), mesurée à 1 kHz, en fonction de la température (axe des abscisses) (montée puis descente) d'un copolymère fluoré électroactif P(VDF-TrFE) de composition molaire 43/57.
La Figure 4 est un graphique illustrant des courbes de permittivité relative (axe des ordonnées), mesurée à 1 kHz, en fonction de la température (axe des abscisses) (montée uniquement représentée) de 4 compositions : (i) ligne brisée noire, terpolymère P(VDF-TrFE-CFE) contenant 6,9 mol % de CFE, (ii) ligne brisée grise, terpolymère P(VDF-TrFE-CFE) avec 8,2 mol % de CFE, (iii) ligne pleine grise, mélange 70-30 massique du terpolymère (ii) avec un copolymère P(VDF-TrFE) de composition molaire 54/46 ; et (iv) ligne pleine noire, mélange 70-30 massique du terpolymère (i) avec un copolymère P(VDF-TrFE) de composition molaire 54/46.

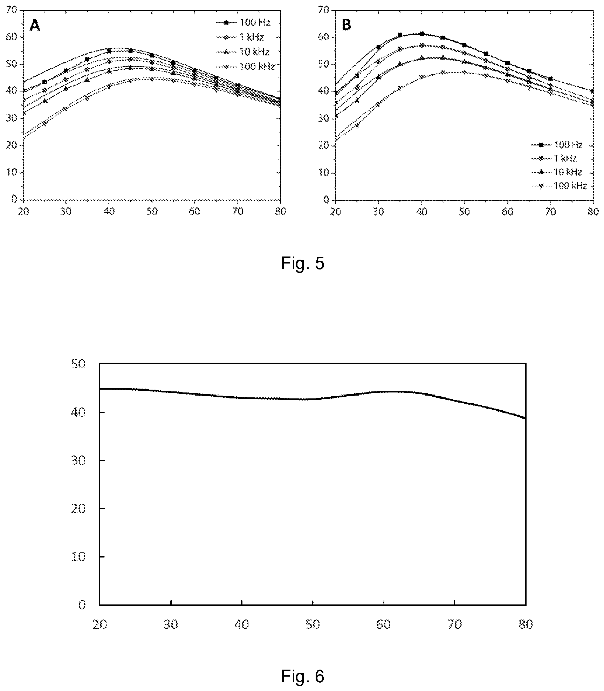

La Figure 5A est un graphique illustrant des courbes de permittivité relative (axe des ordonnées), en fonction de la température (axe des abscisses) (montée et descente) et en fonction de la fréquence du champ électrique (0,1 - 1 - 10 - 100 kHz), d'un mélange 90-10 en masse d'un terpolymère P(VDF-TrFE-CFE) contenant 6,9 mol % de CFE et d'un copolymère P(VDF-TrFE) de composition molaire 54/46. Dans la figure 5B : les courbes de permittivité relative (axe des ordonnées), en fonction de la température (axe des abscisses) et en fonction de la fréquence du champ électrique (0,1 - 1 - 10 - 100 kHz), relatives au même mélange comprenant en outre du PMMA.
La Figure 6 est un graphique illustrant la courbe de permittivité relative (axe des ordonnées), mesurée à 1 kHz, en fonction de la température (axe des abscisses) (montée puis descente) d'un mélange 50-50 en masse d'un copolymère P(VDF-TrFE) de composition molaire 43/57 avec un terpolymère P(VDF-TrFE-CFE) contenant 8,2 mol% de CFE.

### DESCRIPTION DE MODES DE REALISATION DE L'INVENTION

L'invention est maintenant décrite plus en détail et de façon non limitative dans la description qui suit.

L'invention repose d'abord sur l'utilisation d'un terpolymère fluoré (composant a). Par « *fluoré* » on entend un terpolymère comportant des groupements -F.

De préférence, le terpolymère fluoré est un polymère ferroélectrique relaxeur. Un tel matériau présente un champ coercitif faible (typiquement inférieur à 10 V/µm), une polarisation rémanente faible (typiquement inférieure à 10 mC/m²) voire nulle, et un maximum de permittivité diélectrique en fonction de la température dépendant de la fréquence sur champ électrique.

Le terpolymère, de formule P(VDF-X-Y), comprend des unités issues du fluorure de vinylidène (VDF), des unités issues d'un monomère X choisi parmi le trifluoroéthylène (TrFE), le tétrafluoroéthylène, le chlorotrifluoroéthylene (CTFE), le fluorure de vinyle, le 1,1-chlorofluoroéthylène (CFE), l'hexafluoropropène, le 3,3,3-trifluoropropène, le 1,3,3,3-tétrafluoropropène, le 2,3,3,3-tétrafluoropropène, le 1-chloro-3,3,3-trifluoropropène et le 2-chloro-3,3,3-trifluoropropène, et d'un tiers monomère Y.

De manière préférée, le monomère X est le TrFE.

De manière préférée, Y représente des motifs issus du CFE (1-chloro-1-fluoroéthylène) ou du CTFE (chlorotrifluoroéthylène).

Alternativement, le tiers monomère peut notamment être choisi parmi les alcènes halogénés, notamment les propènes ou éthylènes halogénés, et par exemple parmi les tétrafluoropropènes (notamment le 2,3,3,3-tétrafluoropropène), les chlorotrifluoropropènes (notamment le 2-chloro-3,3,3-trifluoropropène), le 1-chloro-2-fluoroéthylène, les trifluoropropènes (notamment le 3,3,3-trifluoropropène), les pentafluoropropènes (notamment le 1,1,3,3,3-pentafluoropropène ou le 1,2,3,3,3-pentafluoropropène), le 1-chloro-2,2-difluoroethylène, le 1-chloro,2-fluoroéthylène, le 1-bromo-2,2-difluoroethylène, le bromotrifluoroéthylène, le fluoroéthylène (ou fluorure de vinyle), le tétrafluoroéthylène et l'hexafluoropropène. Le tiers monomère peut également être un perfluoroalkylvinyléther, de formule générale R_{f}-O-CF-CF₂, R_{f} étant un groupement alkyle, de préférence en C1 à C4. Des exemples préférés sont le PPVE (perfluoropropylvinyléther) et le PMVE (perfluorométhylvinyléther).

Les terpolymères de l'invention peuvent être produits en utilisant tout procédé connu, tel que la polymérisation en émulsion, la polymérisation en micro-émulsion, la polymérisation en suspension et la polymérisation en solution. L'utilisation du procédé décrit dans le document WO 2010/116105 est particulièrement préférée. Ce procédé permet d'obtenir des polymères de poids moléculaire élevé et de structuration adaptée.

Selon un mode de réalisation, la proportion molaire de motifs Y dans le terpolymère vaut de 1 à 15 %, de préférence de 1 à 12 %.

Selon un mode de réalisation, le rapport molaire des motifs VDF sur les motifs TrFE dans le terpolymère vaut de 85/15 à 30/70, et de préférence de 75/25 à 40/60.

Selon un mode de réalisation, la masse molaire moyenne en poids, qui dans le cadre de cette demande est également désignée par «poids moléculaire» (Mw), du terpolymère, vaut de 200 000 à 1 500 000 g/mol, de préférence de 250 000 à 1 000 000 g/mol, et plus particulièrement de 300 000 à 700 000 g/mol.

Cette dernière peut être ajustée par modification de certains paramètres du procédé, tels que la température dans le réacteur, ou par ajout d'un agent de transfert.

La distribution de poids moléculaire peut être estimée par SEC (chromatographie d'exclusion stérique) avec du diméthylformamide (DMF) en tant qu'éluant, avec un ensemble de 3 colonnes de porosité croissante. La phase stationnaire est un gel de styrène-DVB. Le procédé de détection est fondé sur une mesure de l'indice de réfraction, et l'étalonnage est réalisé avec des étalons de polystyrène. L'échantillon est mis en solution à 0,5 g/L dans du DMF et filtré sur un filtre en nylon de 0,45 µm.

Le poids moléculaire peut également être évalué par mesure de l'indice de fluidité à 230°C sous une charge de 5 kg selon ASTM D1238 (ISO 1133).

Par ailleurs, le poids moléculaire peut également être caractérisé par une mesure de la viscosité en solution selon la norme ISO 1628. La méthyléthylcétone (MEK) est un solvant préféré des terpolymères pour la détermination de l'indice de viscosité.

Plus généralement, la composition molaire des terpolymères de l'invention peut être déterminée par divers moyens. Les méthodes classiques d'analyse élémentaire en éléments carbone, fluor et chlore ou brome conduisent à un système de deux ou trois équations indépendantes à deux inconnues indépendantes (par exemple % VDF et % TrFE, avec % Y = 100 - (% VDF + % TrFE)), qui permet de calculer sans ambiguïté la composition massique des polymères, d'où l'on déduit la composition molaire.

On peut également mettre en oeuvre les techniques de RMN multi-noyaux, ici proton (¹H) et fluor (¹⁹F), par analyse d'une solution du polymère dans un solvant deutéré approprié. Le spectre RMN est enregistré sur un spectromètre RMN-FT équipé d'une sonde multi-nucléaire. On repère alors les signaux spécifiques donnés par les différents monomères dans les spectres réalisés selon l'un ou l'autre noyau. Ainsi, par exemple, l'unité TrFE (CFH=CF₂) donne en RMN du proton un signal spécifique caractéristique du groupement CFH (à environ 5 ppm). Il en est de même pour les groupements CH₂ du VDF (massif centré à 3 ppm). L'intégration relative des deux signaux donne l'abondance relative des deux monomères, c'est-à-dire le rapport molaire VDF / TrFE.

La combinaison des intégrations relatives des différents signaux obtenus en RMN du proton et en RMN du fluor conduit à un système d'équations dont la résolution conduit à l'obtention des concentrations molaires des différentes unités monomériques.

Il est enfin possible de combiner l'analyse élémentaire, par exemple pour les hétéroatomes comme le chlore ou le brome, et l'analyse RMN. C'est ainsi que la teneur en CTFE ou en CFE peut être déterminée par une mesure de la teneur en chlore par analyse élémentaire.

L'homme du métier dispose ainsi d'une palette de méthodes ou de combinaison de méthodes lui permettant de déterminer sans ambiguïté et avec la précision nécessaire la composition des terpolymères de l'invention.

L'invention repose ensuite sur l'utilisation d'un copolymère (composant b) de formule P(VDF-TrFE) comprenant des unités issues du fluorure de vinylidène et des unités issues du trifluoroéthylène, compatible avec le terpolymère et présentant une température de Curie différente de celle du terpolymère.

Par « *compatible* » on entend que le mélange des deux polymères forme une phase homogène avec une température de transition vitreuse unique.

De manière caractéristique, dans le copolymère la proportion d'unités issues du trifluoroéthylène est supérieure à 45 mol.% par rapport à la somme des unités issues du fluorure de vinylidène et du trifluoroéthylène, de préférence supérieure à 50 mol.%.

La température de Curie du copolymère est comprise entre 20 et 80 °C. La température de Curie des polymères de l'invention peut être mesurée par calorimétrie différentielle à balayage ou par spectroscopie diélectrique.

La composition selon l'invention est un mélange de polymères fluorés ferroélectriques relaxeurs comprenant au moins un terpolymère fluoré (composant a) et au moins un copolymère P(VDF-TrFE) possédant une composition molaire en TrFE supérieure à 45 mol% (composant b).

Dans la composition selon l'invention, la proportion massique de composant b) est comprise entre 0,1 et 50%, de préférence entre 1 et 45%, avantageusement entre 5 et 40% du poids total de la composition.

La composition de l'invention comprend au moins un terpolymère tel que décrit ci-dessus (éventuellement deux ou plusieurs de ceux-ci), et au moins un copolymère tel que décrit ci-dessus (éventuellement deux ou plusieurs de ceux-ci).

La composition de l'invention peut également comprendre un additif, dont le rôle est d'augmenter la permittivité diélectrique. Selon un mode de réalisation, la composition comprend jusqu'à 2% en poids d'un additif, ledit additif étant un polymère (méth)acrylique, notamment le poly(méthyl méthacrylate) (PMMA).

Un autre objet de l'invention consiste en une formulation (ou encre) à base de polymères fluorés électroactifs comprenant la composition décrite ci-dessus, en solution dans un solvant. Selon un mode de réalisation, ledit solvant est choisi parmi le diméthyl-formamide, le diméthylacétamide, le diméthylsulfoxyde, les cétones, notamment l'acétone, la méthyléthylcétone, la méthylisobutylcétone et la cyclopentanone, les furanes, notamment le tétrahydrofurane ; les esters, notamment l'acétate de méthyle, l'acétate d'éthyle, l'acétate de propyle, l'acétate de butyle et l'acétate de propylène glycol méthyl éther, les carbonates, notamment le diméthylcarbonate, les phosphates, notamment le triéthylphosphate, et les mélanges de ceux-ci.

Le solvant peut être présent dans la formulation, dans une proportion massique d'au moins 50 %, de préférence d'au moins 80 %.

La formulation de l'invention peut être fabriquée en dissolvant ses différents composés dans un solvant. Les polymères fluorés électroactifs peuvent être dissous en même temps dans le solvant, ou l'un après l'autre, ou de manière séparée puis formulations sont mélangées. Il est préféré de dissoudre le terpolymère dans le solvant avant le copolymère.

L'invention fournit notamment des films fabriqués à partir de formulations selon l'invention et déposés sur un substrat. Le substrat peut, par exemple, être un substrat polymérique, tel qu'un substrat de poly(téréphtalate d'éthylène) ou de polyéthylène naphthalate, ou bien encore un substrat du papier, du verre ou du silicium.

De préférence, le film est déposé en voie solvant ou fondue ; puis séché (évaporation du solvant) et recuit pour améliorer sa cristallinité (par chauffage à une température inférieure à la température de fusion et supérieure à la température de Curie de la composition, pendant une durée supérieure ou égale à 1 minute).

Avantageusement, le film selon l'invention possède une permittivité diélectrique relative, dite stable, variant de +/-10, de préférence +/-5, avantageusement +/-2 sur une gamme de températures comprise entre 0 et 100°C, de préférence entre 10-80°C et avantageusement entre 15-70°C.

La mesure de permittivité diélectrique peut être effectuée au moyen d'un LCR mètre Sefelec LCR 819, qui permet de mesurer une capacité qui est proportionnelle à la permittivité.

Ce film est en conséquence adapté à la fabrication de dispositifs électroniques qui exigent pour leur fonctionnement une permittivité stable sur une plage large de températures.

L'invention fournit donc des dispositifs électroniques comprenant un substrat, et au moins un film selon l'invention. On entend par dispositif électronique soit un composant électronique unique, soit un ensemble de composants électroniques, susceptible(s) de remplir une ou des fonctions dans un circuit électronique tels que les transistors (notamment à effet de champ), les puces, les batteries, les cellules photovoltaïques, les diodes électroluminescentes (LED), les diodes électroluminescentes organiques (OLED), les capteurs, les actionneurs, les transformateurs, les dispositifs haptiques, les microsystèmes électromécaniques, les dispositifs électro-caloriques et les détecteurs.

Selon certaines variations, le dispositif électronique est plus particulièrement un dispositif optoélectronique, c'est-à-dire susceptible d'émettre, de détecter ou de contrôler un rayonnement électromagnétique.

Selon un mode de réalisation, le dispositif comporte au moins un film de composition de l'invention et des électrodes de part et d'autre, et forme ainsi un actionneur.

Un autre objet de l'invention concerne un transistor organique à effet de champ comprenant (en référence à la Figure 1 annexée), un élément semi-conducteur (3), des électrodes (1) et une couche diélectrique (2). De manière caractérisante, la couche diélectrique est composée au moins en partie de la composition selon l'invention, dans laquelle la proportion d'unités issues du trifluoroéthylène dans le copolymère b est supérieure à 45 mol.%, de préférence supérieure à 50 mol.% par rapport à la somme des unités issues du fluorure de vinylidène et du trifluoroéthylène.

### EXEMPLES

Les exemples suivants illustrent l'invention sans la limiter.

Une formulation à 7 % en masse dans la butan-2-one (méthyl-éthyl-cétone, MEK) est réalisée en mélangeant le(s) polymère(s) électroactif(s) dans un ballon surmonté d'un réfrigérant droit et chauffé à 80 °C pendant 16 h. Après dissolution complète, la solution est filtrée à 1 µm sur un filtre en PTFE.

Un film d'environ 250 nm est réalisé sur un substrat de silicium sur une tournette à partir de la formulation précédemment préparée. Il est ensuite séché à 60°C pendant 5 min. Les films obtenus sont ensuite recuits à 115°C pendant 2 heures. L'électrode supérieure en or est déposée par évaporation sous vide ou par pulvérisation.

Les propriétés diélectriques des films sont mesurées par spectroscopie d'impédance.

Les différentes compositions étudiées sont présentées dans le tableau 2 ci-dessous.

### Exemple comparatif - Figure 2

Les Figures 2 et 3 montrent une forte évolution de la permittivité diélectrique en fonction de la température. De plus, pour le copolymère P(VDF-TrFE) de composition molaire 70/30, l'hystérésis entre la montée et la descente en température est nette. On a donc pour une même température deux valeurs possibles de permittivité diélectrique, ce qui n'est pas souhaitable pour une utilisation dans les transistors à effet de champ. En revanche pour le le copolymère P(VDF-TrFE) de composition molaire 43/57, l'hystérésis est négligeable.

L'hystérésis observée pour certain copolymères P(VDF-TrFE) est aussi mesurable par calorimétrie différentielle à balayage qui permet de mesurer les températures de Curie au pic de la transition à la chauffe et au refroidissement. Le tableau 1 contient les valeurs de températures de Curie mesurées au pic de la transition par DSC lors du deuxième chauffage et troisième refroidissement. Pour le copolymère P(VDF-TrFE) de composition molaire 43/57, le delta T est inférieur à 2 °C.

L'article de Su R. et al. ; Polymer, 2012, 53, 728-739, DOI:10.1016/j.polymer.2012.01.001 ; confirme l'existence de cette hystérésis, pour un copolymère P(VDF-TrFE) de composition molaire 51/49, avec une température de Curie mesurée à 64 °C en chauffe et à 60 °C au refroidissement.

**Tableau 1**

| | **T_{Curie} (°C)** | | |
|---|---|---|---|
| **Composition molaire en VDF/TrFE** | Deuxième Chauffe | Troisième refroidissement | Delta T |
| 70/30 | 104,7 | 60,1 | 44,6 |
| 55/45 | 63,0 | 60,0 | 4,6 |
| 43/57 | 59,9 | 58,1 | 1,8 |

**Tableau 2**

| **Composition** | **Composant a** | **Composant b** | **% massique** | **Figure** |
|---|---|---|---|---|
| A | P(VDF-TrFE-CTFE) 10 mol% de CTFE | | | 2 courbe tiret-pointillés |
| B | P(VDF-TrFE-CTFE) 4 mol% de CTFE | | | 2 courbe pleine |
| C | | P(VDF-TrFE) 70/30 | | 2 courbe tirets |
| D | | P(VDF-TrFE) 43/57 | | 3 |
| E | P(VDF-TrFE-CFE) 6,9 mol % de CFE | | | 4 Courbe brisée noire |
| F | P(VDF-TrFE-CFE) 8,2 mol % de CFE | | | 4 Courbe brisée grise |
| G | P(VDF-TrFE-CFE) 8,2 mol % de CFE | P(VDF-TrFE) 54/46 | 70/30 | 4 Courbe pleine grise |
| H | P(VDF-TrFE-CFE) 6,9 mol % de CFE | P(VDF-TrFE) 54/46 | 70/30 | 4 Courbe pleine noire |
| I | P(VDF-TrFE-CFE) 6,9 mol % de CFE | P(VDF-TrFE) 54/46 | 90/10 | 5A |
| J | P(VDF-TrFE-CFE) 6,9 mol % de CFE | P(VDF-TrFE) 54/46 | 90/10 + PMMA | 5B |
| K | P(VDF-TrFE-CFE) 8,2 mol % de CFE | P(VDF-TrFE) 43/57 | 50/50 | 6 |

### Exemples selon l'invention - Figures 4 à 6

Les terpolymères seuls présentent une permittivité diélectrique variant fortement avec la température. En revanche, on observe une stabilité de la permittivité diélectrique dans le cas des mélanges étudiés avec un copolymère riche en TrFE (Fig. 4 et 6). L'ajout d'un copolymère ne fait pas apparaitre d'hystérésis dans le mélange (Fig. 5). On observe une augmentation de la permittivité diélectrique. Ce résultat est surprenant et se distingue des exemples du brevet WO 2017/093145 où l'ajout de 3 ou 6 % de PMMA diminue la permittivité (Exemples comparatifs C2 et C3).

## Revendications

1. Composition comprenant un mélange de polymères fluorés électroactifs, ledit mélange étant composé :
a) d'au moins un terpolymère fluoré de formule P(VDF-X-Y) comprenant des unités issues du fluorure de vinylidène (VDF), des unités issues d'un monomère X choisi parmi le trifluoroéthylène (TrFE), le tétrafluoroéthylène, le chlorotrifluoroéthylene (CTFE), le fluorure de vinyle, le 1,1-chlorofluoroéthylène, l'hexafluoropropène, le 3,3,3-trifluoropropène, le 1,3,3,3-tétrafluoropropène, le 2,3,3,3-tétrafluoropropène, le 1-chloro-3,3,3-trifluoropropène et le 2-chloro-3,3,3-trifluoropropène, et d'un tiers monomère Y,
b) et d'au moins un copolymère de formule P(VDF-TrFE) comprenant des unités issues du fluorure de vinylidène et des unités issues du trifluoroéthylène, la proportion d'unités issues du trifluoroéthylène étant supérieure à 45 mol.% par rapport à la somme des unités issues du fluorure de vinylidène et du trifluoroéthylène.

2. Composition selon la revendication 1, dans laquelle le monomère X est le trifluoroéthylène.

3. Composition selon l'une des revendications 1 et 2, dans laquelle le tiers monomère Y est le chlorotrifluoroéthylène ou le 1,1-chlorofluoroéthylène, et la proportion d'unités issues du monomère Y est de 1 à 15 mol.%, de préférence encore de 1 à 12 mol.%, par rapport à la totalité des unités dudit terpolymère.

4. Composition selon l'une des revendications 1 à 3, dans laquelle la proportion massique de composant b) est comprise entre 0,1 et 50%, de préférence entre 1 et 45%, avantageusement entre 5 et 40% du poids total de la composition.

5. Composition selon l'une des revendications 1 à 4, dans laquelle la proportion d'unités issues du trifluoroéthylène dans le copolymère est supérieure à 50 mol.% par rapport à la somme des unités issues du fluorure de vinylidène et du trifluoroéthylène.

6. Composition selon l'une quelconque des revendications 1 à 5, comprenant en outre jusqu'à 2% en poids d'un additif, ledit additif étant un polymère (méth)acrylique, notamment le poly(méthyl méthacrylate).

7. Composition selon l'une quelconque des revendications 1 à 6, ladite composition ayant une permittivité relative εᵣ supérieure à 30 mesurée à 1 kHz, sur une plage de températures allant de 20 à 80°C.

8. Composition selon l'une quelconque des revendications 1 à 7, dans laquelle le terpolymère fluoré électroactif est un terpolymère ferroélectrique relaxeur.

9. Formulation à base de polymères fluorés électroactifs comprenant la composition selon l'une des revendications 1 à 8, en solution dans un solvant.

10. Formulation selon la revendication 9 dans laquelle ledit solvant est choisi parmi le diméthylformamide, le diméthylacétamide, le diméthylsulfoxyde, les cétones, notamment l'acétone, la méthyléthylcétone, la méthylisobutylcétone et la cyclopentanone, les furanes, notamment le tétrahydrofurane ; les esters, notamment l'acétate de méthyle, l'acétate d'éthyle, l'acétate de propyle, l'acétate de butyle et l'acétate de propylène glycol méthyl éther, les carbonates, notamment le diméthylcarbonate, les phosphates, notamment le triéthylphosphate, et les mélanges de ceux-ci.

11. Film polymère constitué de la formulation selon l'une des revendications 9 et 10.

12. Film selon la revendication 11 ayant une permittivité diélectrique relative variant de +/- 10, de préférence +/- 5, avantageusement +/- 2 sur une gamme de températures comprise entre 0 et 100°C, de préférence entre 10-80°C et avantageusement entre 15-70°C.

13. Dispositif (opto)électronique comprenant un substrat, et un film selon l'une des revendications 11 et 12 disposé sur celui-ci.

14. Dispositif selon la revendication 13, comprenant en outre des électrodes de part et d'autre du film, ledit dispositif étant de préférence un actionneur.

15. Transistor à effet de champ comprenant un élément semi-conducteur (3), des électrodes (1) et une couche diélectrique (2), **caractérisé en ce que** la couche diélectrique est composée au moins en partie de la composition selon l'une des revendications 1 à 8.

## Patentansprüche

1. Zusammensetzung, die eine Mischung aus elektroaktiven fluorierten Polymeren umfasst, wobei die Mischung zusammengesetzt ist aus:
a) mindestens einem fluorierten Terpolymer mit der Formel P(VDFE-X-Y), das von Vinylidenfluorid (VDF) abgeleitete Einheiten, von einem Monomer X abgeleitete Einheiten, das ausgewählt ist aus Trifluorethylen (TrFE), Tetrafluorethylen, Chlortrifluorethylen (CTFE), Vinylfluorid, 1,1-Chlorfluorethylen, Hexafluorpropen, 3,3,3-Trifluorpropen, 1,3,3,3-Tetrafluorpropen, 2,3,3,3-Tetrafluorpropen, 1-Chlor-3,3,3-trifluorpropen und 2-Chlor-3,3,3-trifluorpropen und von einem dritten Monomer Y abgeleitete Einheiten umfasst,
b) und mindestens einem Copolymer mit der Formel P(VDF-TrFE), das von Vinylidenfluorid abgeleitete Einheiten und von Trifluorethylen abgeleitete Einheiten umfasst, wobei der Anteil der von Trifluorethylen abgeleiteten Einheiten bezogen auf die Summe der von Vinylidenfluorid und von Trifluorethylen abgeleiteten Einheiten über 45 Mol-% liegt.

2. Zusammensetzung nach Anspruch 1, bei der das Monomer X Trifluorethylen ist.

3. Zusammensetzung nach einem der Ansprüche 1 und 2, wobei das dritte Monomer Y Chlortrifluorethylen oder 1,1-Chlorfluorethylen ist und der Anteil der vom Monomer Y abgeleiteten Einheiten bezogen auf die Gesamtheit der Einheiten des Terpolymers von 1 bis 15 Mol-%, bevorzugter von 1 bis 12 Mol-% beträgt.

4. Zusammensetzung nach einem der Ansprüche 1 bis 3, wobei der Massenanteil von Bestandteil b) zwischen 0,1 und 50%, vorzugsweise zwischen 1 und 45%, vorteilhafterweise zwischen 5 und 40% des Gesamtgewichts der Zusammensetzung beträgt.

5. Zusammensetzung nach einem der Ansprüche 1 bis 4, wobei der Anteil der von Trifluorethylen abgeleiteten Einheiten im Copolymer bezogen auf die Summe der von Vinylidenfluorid und von Trifluorethylen abgeleiteten Einheiten über 50 Mol-% liegt.

6. Zusammensetzung nach einem der Ansprüche 1 bis 5, die ferner bis zu 2 Gewichts-% eines Additivs umfasst, wobei das Additiv ein Methacrylpolymer, insbesondere Polymethylmethacrylat ist.

7. Zusammensetzung nach einem der Ansprüche 1 bis 6, wobei die Zusammensetzung über einen Temperaturbereich von 20 bis 80°C eine bei 1 kHz gemessene relative Permittivitätszahl εᵣ von über 30 aufweist.

8. Zusammensetzung nach einem der Ansprüche 1 bis 7, wobei das elektroaktive fluorierte Terpolymer ein ferroelektrisches Relaxor-Terpolymer ist.

9. Formulierung auf Basis von elektroaktiven fluorierten Polymeren, die die Zusammensetzung nach einem der Ansprüche 1 bis 8 in Lösung in einem Lösungsmittel umfasst.

10. Formulierung nach Anspruch 9, wobei das Lösungsmittel ausgewählt ist aus Dimethylformamid, Dimethylacetamid, Dimethylsulfoxid, Ketonen, insbesondere Aceton, Methylethylketon, Methylisobutylketon und Cyclopentanon, Furanen, insbesondere Tetrahydrofuran; Estern, insbesondere Methylacetat, Ethylacetat, Propylacetat, Butylacetat und Propylenglycolmethyletheracetat, Carbonaten, insbesondere Dimethylcarbonat, Phosphaten, insbesondere Triethylphosphat und Mischungen daraus.

11. Polymerfilm, der aus der Formulierung nach einem der Ansprüche 9 und 10 besteht.

12. Film nach Anspruch 11, die eine relative dielektrische Permittivitätszahl aufweist, die in einem Temperaturbereich zwischen 0 und 100°C, vorzugsweise zwischen 10 und 80°C und vorteilhafterweise zwischen 15 bis 70°C um +/- 10, vorzugsweise +/- 5, vorteilhafterweise +/- 2 schwankt.

13. Optoelektronische Vorrichtung, die ein Substrat und einen Film nach einem der Ansprüche 11 und 12 umfasst, der darauf angeordnet ist.

14. Vorrichtung nach Anspruch 13, die ferner Elektroden auf beiden Seiten des Films umfasst, wobei die Vorrichtung vorzugsweise ein Aktor ist.

15. Feldeffekttransistor, der ein Halbleiterelement (3), Elektroden (1) und eine dielektrische Schicht (2) umfasst, **dadurch gekennzeichnet, dass** die dielektrische Schicht zumindest teilweise aus der Zusammensetzung nach einem der Ansprüche 1 bis 8 aufgebaut ist.

## Claims

1. Composition comprising a blend of fluorinated electroactive polymers, said blend being composed of:
a) at least one fluorinated terpolymer of formula P(VDF-X-Y) comprising units derived from vinylidene fluoride (VDF), units derived from a monomer X chosen from trifluoroethylene (TrFE), tetrafluoroethylene, chlorotrifluoroethylene (CTFE), vinyl fluoride, 1,1-chlorofluoroethylene, hexafluoropropene, 3,3,3-trifluoropropene, 1,3,3,3-tetrafluoropropene, 2,3,3,3-tetrafluoropropene, 1-chloro-3,3,3-trifluoropropene and 2-chloro-3,3,3-trifluoropropene, and a third monomer Y,
b) and of at least one copolymer of formula P(VDF-TrFE) comprising units derived from vinylidene fluoride and units derived from trifluoroethylene, the proportion of units derived from trifluoroethylene being greater than 45 mol% relative to the sum of the units derived from vinylidene fluoride and trifluoroethylene.

2. Composition according to Claim 1, wherein the monomer X is trifluoroethylene.

3. Composition according to one of Claims 1 and 2, wherein the third monomer Y is chlorotrifluoroethylene or 1,1-chlorofluoroethylene, and the proportion of units derived from the monomer Y is from 1 to 15 mol%, more preferably from 1 to 12 mol%, relative to the entirety of the units of said terpolymer.

4. Composition according to one of Claims 1 to 3, wherein the proportion by weight of component b) is between 0.1% and 50%, preferably between 1% and 45% and advantageously between 5% and 40% of the total weight of the composition.

5. Composition according to one of Claims 1 to 4, wherein the proportion of units derived from trifluoroethylene in the copolymer is greater than 50 mol% relative to the sum of the units derived from vinylidene fluoride and from trifluoroethylene.

6. Composition according to any one of Claims 1 to 5, further comprising up to 2% by weight of an additive, said additive being a (meth)acrylic polymer, in particular poly(methyl methacrylate).

7. Composition according to any one of Claims 1 to 6, said composition having a relative permittivity εᵣ of greater than 30 measured at 1 kHz over a temperature range from 20 to 80°C.

8. Composition according to any one of Claims 1 to 7, wherein the fluorinated electroactive terpolymer is a relaxor ferroelectric terpolymer.

9. Formulation based on fluorinated electroactive polymers comprising the composition according to one of Claims 1 to 8 in solution in a solvent.

10. Formulation according to Claim 9, wherein said solvent is chosen from dimethylformamide, dimethylacetamide, dimethyl sulfoxide, ketones, in particular acetone, methyl ethyl ketone, methyl isobutyl ketone and cyclopentanone, furans, in particular tetrahydrofuran, esters, in particular methyl acetate, ethyl acetate, propyl acetate, butyl acetate and propylene glycol methyl ether acetate, carbonates, in particular dimethyl carbonate, phosphates, in particular triethyl phosphate, and mixtures thereof.

11. Polymer film consisting of the formulation according to one of Claims 9 and 10.

12. Film according to Claim 11, having a relative dielectric permittivity that varies by ± 10, preferably ± 5, advantageously ± 2, over a temperature range between 0 and 100°C, preferably between 10-80°C and advantageously between 15-70°C.

13. (Opto)electronic device comprising a substrate and a film according to one of Claims 11 and 12 deposited on the substrate.

14. Device according to Claim 13, further comprising electrodes on either side of the film, said device preferably being an actuator.

15. Field-effect transistor comprising a semiconductor element (3), electrodes (1) and a dielectric layer (2), **characterized in that** the dielectric layer is at least partly composed of the composition according to one of Claims 1 to 8.w
